# EUROPÄISCHE PATENTSCHRIFT

(11) **EP 3 531 082 B1**
(45) Veröffentlichungstag und Bekanntmachung des Hinweises auf die Patenterteilung: **23.12.2020**
(21) Anmeldenummer: 19155635.6
(22) Anmeldetag: 06.02.2019
(51) Int. Cl.: G01D 21/00

(54) **VERFAHREN UND COMPUTERPROGRAMMPRODUKT ZUR ERMITTLUNG EINER MESSKETTE FÜR DIE ERFASSUNG EINER PHYSIKALISCHEN MESSGRÖSSE**
METHOD AND COMPUTER PROGRAM PRODUCT FOR DETERMINING A MEASURING CHAIN FOR ACQUIRING A PHYSICAL MEASURING QUANTITY
PROCÉDÉ ET PRODUIT PROGRAMME INFORMATIQUE POUR LA DÉTERMINATION D'UNE CHAÎNE DE MESURE PERMETTANT L'ACQUISITION D'UNE GRANDEUR DE MESURE PHYSIQUE

(30) Priorität: 23.02.2018 EP 18158312
(43) Veröffentlichungstag der Anmeldung: 28.08.2019
(73) Patentinhaber: Kistler Holding AG, 8408 Winterthur (CH)
(72) Erfinder: Angliker, Marco, 8032 Zürich (CH); Ehrensperger, Viola, 8444 Henggart (CH); De Simoni, Frederic, 5000 Aarau (CH); Lauffer, Michael, 8180 Bülach (CH)

(56) Entgegenhaltungen:
- FOWLER K R ET AL: "Sensors: the first stage in the measurement chain. 2. In a series of tutorials in instrumentation and measurement", IEEE INSTRUMENTATION & MEASUREMENT MAGAZINE, IEEE SERVICE CENTER, PISCATAWAY, NJ, US, Bd. 7, Nr. 3, September 2004 (2004-09), Seiten 60-66, XP011119793, ISSN: 1094-6969, DOI: 10.1109/MIM.2004.1337915
- RAUTH D A ET AL: "Sensors and signal conditioning", IEEE INSTRUMENTATION & MEASUREMENT MAGAZINE, IEEE SERVICE CENTER, PISCATAWAY, NJ, US, Bd. 8, Nr. 2, Juni 2005 (2005-06), Seiten 48-53, XP011133541, ISSN: 1094-6969, DOI: 10.1109/MIM.2005.1518622
- BETTA G ET AL: "Experimental design techniques for optimising measurement chain calibration", MEASUREM, INSTITUTE OF MEASUREMENT AND CONTROL. LONDON, GB, Bd. 30, Nr. 2, September 2001 (2001-09), Seiten 115-127, XP004248725, ISSN: 0263-2241, DOI: 10.1016/S0263-2241(00)00060-9
- Kistler: "The entire measuring chain from a single source", Company brochure, 2018, Seiten 1-4, XP055498146, Gefunden im Internet: URL:https://www.kistler.com/uploads/961-12 1e.pdf [gefunden am 2018-08-07]

## Beschreibung

### Technisches Gebiet

Die Erfindung betrifft ein Verfahren und ein Computerprogrammprodukt zur Erfassung einer physikalischen Messgrösse nach dem Oberbegriff des unabhängigen Anspruchs.

### Stand der Technik

Bekanntlich wird eine physikalische Messgrösse mit einem Messsystem erfasst. Die physikalische Messgrösse kann eine Kraft, ein Druck, eine Masse, eine Temperatur, usw. sein. Die physikalische Messgrösse wird dabei als Messwert nach Zahl und Einheit dargestellt. Die Einheit ist üblicherweise in Newton (N), Pascal (N/m²), Kilogramm (kg), Kelvin (K), usw. normiert.

Im Allgemeinen sind mehrere zeitlich und räumlich voneinander getrennte Schritte notwendig, um die physikalische Messgrösse zu erfassen. Beispielsweise wird ein Druck in einem Messraum erfasst, dafür erzeugt ein im Messraum angeordneter piezoelektrischer Drucksensor zum Druck proportionale elektrische Ladung und übermittelt sie über ein Signalkabel als Messsignal zu einer räumlich vom Messraum entfernten Auswerteeinheit. Dort wird das Messsignal aufbereitet, beispielsweise wird das Messsignal elektrisch verstärkt und das elektrisch verstärkte Messsignal wird auf einer Anzeige als Messwert dargestellt. Die Messung der elektrischen Ladung erfolgt zeitlich vor der Übermittlung des Messsignals und vor der Aufbereitung des Messsignals und vor der Darstellung des Messwertes. Ein solches Messsystem weist also mehrere Übertragungsglieder wie Sensor, Messkabel und Auswerteeinheit auf, welche Übertragungsglieder eine Messkette bilden. Direkt benachbarte Übertragungsglieder der Messkette stehen für die Erfassung der physikalischen Messgrösse in einer Ursache-Wirkung-Beziehung zueinander.

Das Dokument Fowler K. R. et al., "Sensors: The First Stage in the Measurement Chain, Part 2 in a series of tutorials in instrumentation and measurement", IEEE Instrumentation & Measurement Magazine September 2004, Seiten 60-66, XP011119793 liefert eine Definition der wichtigsten Begriffe einer Messkette wie Messgrösse, Messsignal, Sensor, Messkabel, Auswerteeinheit und Messwert und erklärt mit einer Transferfunktion das Verhältnis von Messsignal und physikalischer Messgrösse.

Und das Dokument Rauth D. A. et al., "Sensor and Signal Conditioning, Part 4 in a series of tutorials in instrumentation and measurement", IEEE Instrumentation & Measurement Magazine Juni 2005, Seiten 48-53, XP011133541 liefert Details zur Aufbereitung des Messignals, wobei die Transferfunktion mathematisch modelliert wird.

Die Erfassung der physikalischen Messgrösse ist Leistungskriterien wie Verfügbarkeit, Messempfindlichkeit, Anzahl der Kanäle, Messunsicherheit, usw. unterworfen. So wird eine Messkette oft nur deshalb aus örtlich vorhandenen Übertragungsgliedern zusammengestellt, weil diese einfach und rasch verfügbar sind. Tatsächlich sind solche verfügbaren Übertragungsgliedern für die Erfassung der physikalischen Messgrösse suboptimal geeignet, beispielsweise weil eine Messempfindlichkeit eines verfügbaren piezoelektrischen Drucksensors zu gering ist, oder weil eine Auswerteeinheit zu wenige Kanäle aufweist.

Aufgabe der vorliegenden Erfindung ist es, ein Verfahren zur : Ermittlung einer bestmöglichen Messkette aus mehreren Messketten für die Erfassung einer physikalischen Messgrösse bereitzustellen, welches Verfahren die im Rahmen der Leistungskriterien bestmögliche Messkette mit geringem zeitlichen und materiellen Aufwand ermittelt.

### Darstellung der Erfindung

Diese Aufgabe wird durch die Merkmale des unabhängigen Anspruchs 1 gelöst.

Die Erfindung betrifft ein Verfahren zur Ermittlung einer bestmöglichen Messkette aus mehreren Messketten für die Erfassung einer physikalischen Messgrösse durch ein Messsystem; welches Messsystem mehrere Übertragungsglieder aufweist; welche Übertragungsglieder : zur Bildung verschiedener Messketten für die Erfassung der physikalischen Messgrösse geeignet sind, wobei in den Messketten jeweils direkt benachbarte Übertragungsglieder in einer Ursache-Wirkung-Beziehung zueinander stehen. Die Erfindung umfasst die Schritte: a) Angabe der zu erfassenden physikalischen Messgrösse; b) Automatisierte Zusammenstellung mehrerer Messketten mit für die Erfassung der angegebenen physikalischen Messgrösse notwendigen Übertragungsgliedern; c) Automatisierte Ermittlung von Leistungskriterien der zusammengestellten Messketten; d) Vergleich der zusammengestellten Messketten miteinander anhand der ermittelten Leistungskriterien; und e) Identifizierung einer Messkette, welche identifizierte Messkette eines der ermittelten Leistungskriterien am besten erfüllt.

Die Patentanmelderin hat herausgefunden, dass sie als kommerzielle Anbieterin von Messsystemen ausreichend Expertenwissen hat, um einem Benutzer bei der Zusammenstellung der zur Erfassung einer physikalischen Messgrösse benötigten Messkette zu helfen.

Hier setzt die Erfindung ein. Der Benutzer gibt die zu erfassende physikalische Messgrösse an. Vorzugsweise macht der Benutzer hier bereits auch Vorgaben zu Leistungskriterien, der Benutzer gibt dann vor, was nach welchen Leistungskriterien gemessen werden soll. Nun wird dem Benutzer das Expertenwissen der Anmelderin bereitgestellt. Für den Benutzer werden mehrere Messketten mit zur Erfassung der angegebenen physikalischen Messgrösse notwendigen Übertragungsgliedern automatisiert zusammengestellt. Eine automatisierte Zusammenstellung mehrerer Messketten im Sinne der Erfindung ist eine selbsttätige Zusammenstellung mehrerer Messketten durch ein Computerprogrammprodukt ohne Einwirkung des Benutzers. Dadurch erhält der Benutzer Expertenwissen über mögliche Varianten bei der Erfassung der physikalischen Messgrösse. Für die zusammengestellten Messketten werden nun Leistungskriterien ermittelt. Vorzugsweise werden dabei Vorgaben zu Leistungskriterien berücksichtigt. Jetzt lassen sich die zusammengestellten Messketten nach den ermittelten Leistungskriterien vergleichen. Die ermittelten Leistungskriterien ermöglichen eine leistungsspezifische Rangbildung. So kann diejenige zusammengestellte Messkette identifiziert werden, welche Messkette eines der ermittelten Leistungskriterien am besten erfüllt. Der Benutzer erhält so mit geringem zeitlichen und materiellen Aufwand eine Messkette automatisiert zusammengestellt.

Die Schritte a) bis e) im erfinderischen Verfahren zur Erfassung einer physikalischen Messgrösse werden durch ein Computerprogrammprodukt ausgeführt.

### Kurze Beschreibung der Zeichnungen

Im Folgenden wird die Erfindung beispielhaft unter Beizug der Figuren näher erklärt. Es zeigen
- Fig. 1: eine Darstellung eines Messsystems S mit mehreren Übertragungsgliedern G1-G4;
- Fig. 2: ein Schema von Schritten a) bis e) beim Verfahren V zur Erfassung einer physikalischen Messgrösse M des Messsystems S nach Fig. 1;
- Fig. 3: eine Darstellung eines Rechensystems R für ein Computerprogrammprodukt C zur Durchführung des Verfahrens V nach Fig. 2;
- Fig. 4: eine Darstellung einer Eingabeeinheit R3 des Rechensystems R nach Fig. 3 zur Durchführung von Schritt a) des Verfahrens V nach Fig. 2;
- Fig. 5: ein Schema von Teilschritten ca) bis cd) beim Schritt c) des Verfahrens V nach Fig. 2; und
- Fig. 6: eine Darstellung einer Ausgabeeinheit R4 des Rechensystems R nach Fig. 3 zur Durchführung der Schritte d) und e) des Verfahrens V nach Fig. 2.

### Wege zur Ausführung der Erfindung

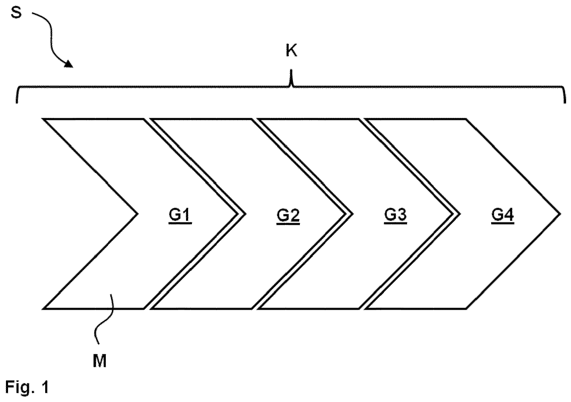

Fig. 1 zeigt ein Ausführungsbeispiel eines Messsystems S mit mehreren Übertragungsgliedern G1-G4. Wie einleitend dargelegt, dient das Messsystem S dazu, eine physikalische Messgrösse M zu erfassen. Dazu bilden die Übertragungsglieder G1-G4 eine Messkette K. Gemäss Konvention der Erfindung ist G1-G4 eine Kurzform von G1, G2, G3, G4. Direkt benachbarte Übertragungsglieder G1-G4 der Messkette K, beispielsweise die Übertragungsglieder G1 und G2, oder die Übertragungsglieder G2 und G3, stehen für die Erfassung der physikalischen Messgrösse M in einer Ursache-Wirkung-Beziehung zueinander. Im Ausführungsbeispiel nach Fig. 1 sind vier Übertragungsglieder G1-G4 dargestellt, bei Kenntnis der Erfindung kann der Fachmann natürlich ein Messsystem mit mehr oder weniger Übertragungsgliedern realisieren.

Ein erstes Übertragungsglied G1-G1 ist ein Sensor, wie ein Drucksensor, ein Beschleunigungssensor, ein Temperatursensor, usw. Der Sensor misst dementsprechend die physikalische Messgrösse M wie Druck, Beschleunigung, Temperatur, usw. und erzeugt ein analoges Messsignal wie einen elektrischen Strom, eine elektrische Spannung, usw. Im Folgenden wird der Sensor in der beispielhaften Ausführungsform eines piezoelektrischen Sensors beschrieben. Bei einem piezoelektrischen Sensor ist das analoge Messsignal weitgehend proportional zur physikalischen Messgrösse M. Ein piezoelektrischer Sensor misst einen Druck mit einer Messempfindlichkeit von einigen pC/bar oder eine Kraft mit einer Messempfindlichkeit von einigen pC/N. Ein piezoelektrischer Sensor mit integrierter Elektronik misst eine Beschleunigung mit einer Messempfindlichkeit von einigen mV/g. Die Messempfindlichkeit ändert sich jedoch mit der Umgebungstemperatur und dem Alter des piezoelektrischen Sensors. Die altersbedingte Änderung der Messempfindlichkeit lässt sich durch einen Zeitabstand seit einer letzten Kalibrierung und eine Genauigkeit der Kalibrierung kompensieren. Je öfter und je genauer ein piezoelektrischer Sensor kalibriert wird, desto besser ist die altersbedingte Änderung der Messempfindlichkeit bekannt. Auch weist das analoge Messsignal eine geringe Abweichung von der Proportionalität zur physikalischen Messgrösse M auf, was als Linearität des piezoelektrischen Sensors bezeichnet wird. Der piezoelektrische Sensor ist für eine maximale Betriebstemperatur ausgelegt. Schliesslich ist das analoge Messsignal nur mit einer Messgenauigkeit des piezoelektrischen Sensors reproduzierbar, was auch von Umgebungseinflüssen wie Vibrationen, hohe Temperaturen, elektromagnetischen Feldern, usw. abhängt.

Die "Messempfindlichkeit des piezoelektrischen Sensors" ist ein erster technischer Kenngrössenbeitrag T11 des ersten Übertragungsgliedes G1. Die "Linearität des piezoelektrischen Sensors" ist ein zweiter technischer Kenngrössenbeitrag T12 des ersten Übertragungsgliedes G1. Die "Messgenauigkeit des piezoelektrischen Sensors" ist ein dritter technischer Kenngrössenbeitrag T13 des ersten Übertragungsgliedes G1.

Eine "Verfügbarkeit des piezoelektrischen Sensors" ist ein erster physischer Kenngrössenbeitrag P11 des ersten Übertragungsgliedes G1. Ein "Beschaffungspreis des piezoelektrischen Sensors" ist ein zweiter physischer Kenngrössenbeitrag P12 des ersten Übertragungsgliedes G1.

Eine "Temperaturabhängigkeit der Messempfindlichkeit des piezoelektrischen Sensors" ist eine erste für die Messunsicherheit U relevante Einflussgrösse E12 des ersten Übertragungsgliedes G1. Ein "Zeitabstand seit der letzten Kalibrierung und eine Genauigkeit der Kalibrierung" ist eine zweite für die Messunsicherheit U relevante Einflussgrösse E22 des ersten Übertragungsgliedes G1. "Umgebungseinflüsse" sind eine dritte für die Messunsicherheit U relevante Einflussgrösse E13 des ersten Übertragungsgliedes G1.

Ein zweites Übertragungsglied G2 ist ein Signalkabel, welches Signalkabel das analoge Messsignal vom Sensor zu einem elektrischen Verstärker überträgt. Das Messsignal kann eine Frequenz von mehreren GHz haben. Eine Kabelimpedanz des Signalkabels ist hier wesentlich. Die Kabelimpedanz ist ein Wellenwiderstand, den das Signalkabel einer Ausbreitung des Messsignals in Form von elektromagnetischen Wellen entgegenbringt. Ist das Signalkabel nicht mit einem elektrischen Widerstandselement abgeschlossen, kommt es im Signalkabel zu störenden Reflexionen des Messsignals. Die Kabelimpedanz ist von der Höhe der Frequenz abhängig.

Die "Kabelimpedanz" ist ein erster technischer Kenngrössenbeitrag T21 des zweiten Übertragungsgliedes G2. Die "Frequenz" ist ein zweiter technischer Kenngrössenbeitrag T22 des zweiten Übertragungsgliedes G2.

Eine "Verfügbarkeit des Signalkabels" ist ein erster physischer Kenngrössenbeitrag P21 des zweiten Übertragungsgliedes G2. Ein "Beschaffungspreis des Signalkabels" ist ein zweiter physischer Kenngrössenbeitrag P22 des zweiten Übertragungsgliedes G2.

Eine "Länge des Signalkabels" ist eine erste für die Messunsicherheit U relevante Einflussgrösse E21 des zweiten Übertragungsgliedes G2. Die "Frequenz" ist auch eine zweite für die Messunsicherheit U relevante Einflussgrösse E22 des zweiten Übertragungsgliedes G2.

Ein drittes Übertragungsglied G3 ist der elektrische Verstärker, welcher elektrische Verstärker das übertragene analoge Messsignal empfängt und elektrisch verstärkt und zu einem digitalen Messsignal wandelt. Der elektrische Verstärker kann über mehrere Kanäle gleichzeitig analoge Messsignale empfangen. Eine Abtastfrequenz kann je nach Anzahl der Kanäle von bis zu 1000kS/s pro Kanal betragen. Eine Messgenauigkeit des elektrischen Verstärkers hängt auch von der Auflösung pro Kanal von beispielsweise 16Bit oder 32Bit ab.

Die "Anzahl der Kanäle" ist ein erster technischer Kenngrössenbeitrag T31 des dritten Übertragungsgliedes G3. Die "Abtastfrequenz" ist ein zweiter technischer Kenngrössenbeitrag T32 des dritten Übertragungsgliedes G3. Die "Messgenauigkeit des elektrischen Verstärkers" ist ein dritter technischer Kenngrössenbeitrag T33 des dritten Übertragungsgliedes G3.

Eine "Verfügbarkeit des elektrischen Verstärkers" ist ein erster physischer Kenngrössenbeitrag P31 des dritten Übertragungsgliedes G3. Ein "Beschaffungspreis des elektrischen Verstärkers" ist ein zweiter physischer Kenngrössenbeitrag P32 des dritten Übertragungsgliedes G3.

Die "Messgenauigkeit des elektrischen Verstärkers" ist eine erste für die Messunsicherheit U relevante Einflussgrösse E31 des dritten Übertragungsgliedes G3. Ein "Übersprechen zwischen Eingangskanälen des elektrischen Verstärkers" ist eine zweite für die Messunsicherheit U relevante Einflussgrösse E32 des dritten Übertragungsgliedes G3.

Ein viertes Übertragungsglied G4 ist eine Auswerteeinheit, welche Auswerteeinheit das digitale Messsignal auswertet. Die Auswerteeinheit weist einen Datenverarbeitungsprozessor, einen Datenspeicher und einen Bildschirm auf. Über eine Vielzahl von Schnittstellen wird nicht nur das digitale Messsignal vom elektrischen Verstärker an die Auswerteeinheit übermittelt, sondern die Auswerteeinheit kann den elektrischen Verstärker so auch steuern. Zur Auswertung kann das digitale Messsignal in ein im Datenverarbeitungsprozessor laufendes Computerprogrammprodukt geladen werden. Vom Computerprogrammprodukt kann das digitale Messsignal weiterverarbeitet werden. Je nach Version des geladenen Computerprogrammproduktes, kann die Auswerteeinheit das digitale Messsignal mehr oder weniger vielfältig weiterverarbeiten. Das digitale Messsignal kann im Datenspeicher gespeichert werden. Auch kann das digitale Messsignal auf dem Bildschirm dargestellt werden.

Eine "Vielzahl der Schnittstellen" ist ein erster technischer Kenngrössenbeitrag T41 des vierten Übertragungsgliedes G4. Eine "Version des Computerprogrammproduktes" ist ein zweiter technischer Kenngrössenbeitrag T42 des vierten Übertragungsgliedes G4.

Eine "Verfügbarkeit der Auswerteeinheit" ist ein erster physischer Kenngrössenbeitrag P41 des vierten Übertragungsgliedes G4. Ein "Beschaffungspreis der Auswerteeinheit" ist ein zweiter physischer Kenngrössenbeitrag P42 des vierten Übertragungsgliedes G4.

"Rundungsfehler bei der Weiterverarbeitung" sind eine erste für die Messunsicherheit U relevante Einflussgrösse E41 des vierten Übertragungsgliedes G4. Eine "Geschwindigkeit bei der Weiterverarbeitung" ist eine zweite für die Messunsicherheit U relevante Einflussgrösse E42 des vierten Übertragungsgliedes G4.

Bei Kenntnis der vorliegenden Erfindung kann der Fachmann ein Messsystem mit anderen Übertragungsgliedern und mit anderen technischen Kenngrössenbeiträgen und anderen physischen Kenngrössenbeiträgen und anderen für die Messunsicherheit relevanten Einflussgrössen realisieren.

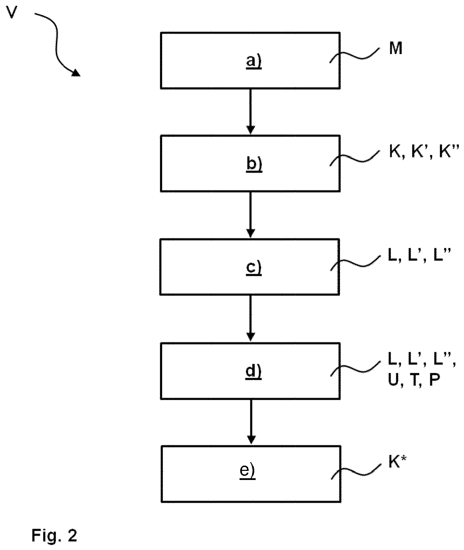

Fig. 2 ist ein Schema von Schritten a) bis e) beim Verfahren V zur Ermittlung einer bestmöglichen Messkette aus mehreren Messketten für die Erfassung einer physikalischen Messgrösse M. Im Schritt a) wird die zu erfassende physikalische Messgrösse M angegeben. Im Schritt b) erfolgt eine Zusammenstellung mehrerer Messketten K-K" mit für die Erfassung der angegebenen physikalischen Messgrösse M notwendigen Übertragungsgliedern G1-G4". Im Schritt c) werden Leistungskriterien L-L" der zusammengestellten Messketten K-K" ermittelt. Im Schritt d) werden die zusammengestellten Messketten K-K" anhand der ermittelten Leistungskriterien L-L" miteinander verglichen. Und im Schritt e) wird diejenige Messkette K* identifiziert, welche identifizierte Messkette K* eines der ermittelten Leistungskriterien L-L" am besten erfüllt. Gemäss Konvention der Erfindung ist K-K" oder L-L" eine Kurzform von K, K', K" oder L, L', L". Gemäss Konvention der Erfindung ist G1-G4" eine Kurzform von G1-G4, G1'-G4', G1"-G4".

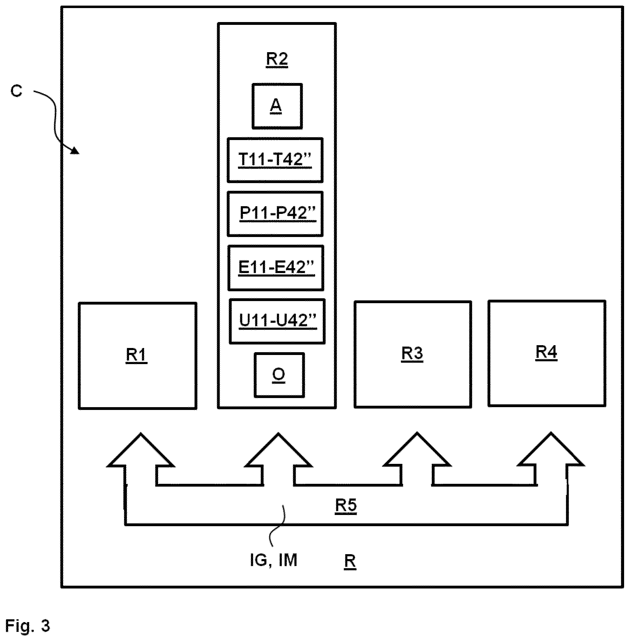

Fig. 3 zeigt ein Rechensystem R für ein Computerprogrammprodukt C zur Durchführung des Verfahrens V. Das Rechensystem R weist als Bestandteile einen Datenverarbeitungsprozessor R1, einen Datenspeicher R2, mindestens eine Eingabeeinheit R3, eine Ausgabeeinheit R4 und mindestens eine Kommunikationseinheit R5 auf. Das Rechensystem R kann ein handelsüblicher Computer sein. Die Eingabeeinheit R3 kann eine Computer-Tastatur, eine Computer-Maus, ein berührungsempfindlicher Bildschirm, eine Datenschnittstelle, usw. sein. Die Ausgabeeinheit R4 kann ein Computer-Bildschirm, ein berührungsempfindlicher Bildschirm, usw. sein. Die Kommunikationseinheit R5 kommuniziert Daten zwischen den Bestandteilen des Rechensystems R. Die Kommunikationseinheit R5 kann ein Netzwerk wie das Internet, ein Computer-Bus wie der Peripheral Component Interconnect Express (PCIe) Bus, usw. sein. Die Datenschnittstelle ist mit der Kommunikationseinheit R5 in der Ausführungsform eines Netzwerks verbunden, sie kann im Netzwerk gemäss einem Netzwerkprotokoll wie dem Internet-Protokoll (IP), dem PCIe-Protokoll kommunizieren, und sie ist im Netzwerk über eine Netzwerkadresse aufrufbar.

Einzelne Bestandteile des Rechensystems R können beim Messsystem S des Benutzers angeordnet sein, sie können aber auch entfernt vom Messsystem S des Benutzers angeordnet sein. Unter "entfernt" wird im Sinne der Erfindung eine beliebig grosse Entfernung von grösser 30m verstanden. Auch die Bestandteile des Rechensystems R können beliebig weit entfernt voneinander angeordnet sein. So können nur die Eingabeeinheit R3 und die Ausgabeeinheit R4 beim Benutzer angeordnet sein, während der Datenverarbeitungsprozessor R1 und der Datenspeicher R2 entfernt vom Benutzer angeordnet sind. Auch können die Bestandteile des Rechensystems R mehrmals vorhanden sein. So ist es möglich, dass beim Benutzer eine erste Eingabeeinheit und eine erste Ausgabeeinheit angeordnet sind, während entfernt vom Benutzer eine zweite Eingabeeinheit angeordnet ist. Und es ist möglich, dass das Rechensystem R eine erste Kommunikationseinheit und eine zweite Kommunikationseinheit aufweist.

Das Computerprogrammprodukt C ist im Datenspeicher R2 speicherbar und aus dem Datenspeicher R2 in den Datenverarbeitungsprozessor R1 ladbar und zur Durchführung des Verfahrens V zur Ermittlung der Messunsicherheit U des Messsystems S im Datenverarbeitungsprozessor R1 ausführbar.

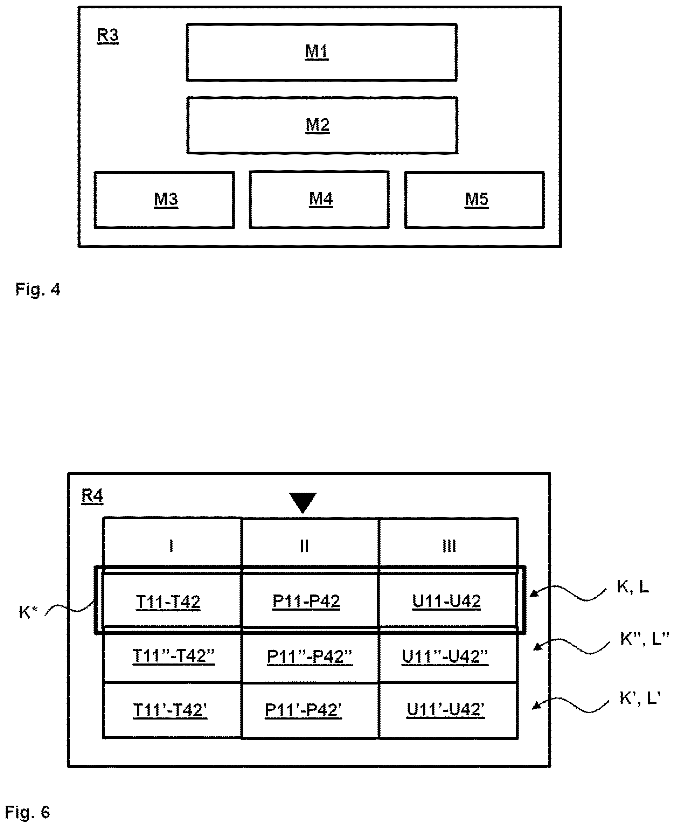

Im Schritt a) werden digitale Informationen IM zur Angabe der zu erfassenden physikalischen Messgrösse M erzeugt. Beispielsweise soll in einem Messraum eine Kraft und eine Beschleunigung erfasst werden. Dazu kann der Benutzer auf der Eingabeeinheit R3 in der Ausführungsform einer Computer-Tastatur die Buchstaben "Kraft erfassen" und "Beschleunigung erfassen" eingeben und so digitale Informationsdaten IM zur Angabe der zu erfassenden physikalischen Messgrösse M erzeugen. Oder der Benutzer gibt die zu erfassende physikalische Messgrösse M auf der Eingabeeinheit R3 in der Ausführungsform eines berührungsempfindlichen Bildschirms nach Fig. 4 durch Auswahl von darauf abgebildeten Eingabefeldern M1-M6 an. Für eine Krafterfassung im Messraum berührt der Benutzer ein erstes Eingabefeld M1 "Kraft erfassen". Für eine Beschleunigungserfassung im Messraum berührt der Benutzer ein zweites Eingabefeld M2 "Beschleunigung erfassen". Durch diese Berührung werden digitale Informationsdaten IM zur Angabe der zu erfassenden physikalischen Messgrösse M erzeugt.

Optional werden im Schritt a) auch digitale Informationsdaten IM zur Vorgabe von Leistungskriterien L-L" erzeugt. Auch dies kann über eine Computer-Tastatur oder einen berührungsempfindlichen Bildschirm erfolgen. So kann der Benutzer über ein drittes Eingabefeld M3 "Vier Kanäle, ein Kanal für die Krafterfassung, drei Kanäle für die Beschleunigungserfassung" einen technischen Kenngrössenbeitrag T31 vorgeben. Auch kann der Benutzer über ein viertes Eingabefeld M4 "Erfassungszeitraum vom 01.03.2020 bis 31.03.2020" physische Kenngrössenbeiträge P11, P21, P31, P41 vorgeben. Und der Benutzer kann über ein fünftes Eingabefeld M5 "mittlere Messunsicherheit" eine Messunsicherheit U vorgeben.

An der Eingabeeinheit R3 erzeugte digitale Informationsdaten IM werden über die Kommunikationseinheit R5 zum Datenverarbeitungsprozessor R1 kommuniziert und dort vom Computerprogrammprodukt C eingelesen. Es ist auch möglich, dass das Computerprogrammprodukt C digitale Informationsdaten IM zur Angabe der zu erfassenden physikalischen Messgrösse M selbsttätig erzeugt, beispielsweise im Rahmen eines beliebigen industriellen Produktionsprozesses. Und das Computerprogrammprodukt C kann auch eine Vorgabe zu Leistungskriterien L-L" selbsttätig erzeugen, beispielsweise in dem Erfahrungswerte für Leistungskriterien L-L" berücksichtigt werden, mit welchen Erfahrungswerten für Leistungskriterien L-L" in früheren industriellen Produktionsprozessen Gutteile produziert worden sind.

Bei Kenntnis der vorliegenden Erfindung kann der Fachmann Schritt a) des Verfahrens mit anderen Eingabefeldern für andere zu erfassende physikalische Messgrössen und andere technische Kenngrössenbeiträge und andere physische Kenngrössenbeiträge und eine andere Messunsicherheit realisieren.

Digitale Informationsdaten IG von sehr vielen Übertragungsgliedern G1-G4" sind verfügbar. Beispielsweise sind im Datenspeicher R2 digitale Informationsdaten IG von sehr vielen Übertragungsgliedern G1-G4" gespeichert. Die digitalen Informationsdaten IG eines jeden Übertragungsgliedes G1-G4" bezeichnen mindestens einen Anwendungszweck A, mindestens einen technischen Kenngrössenbeitrag T11-T42'', mindestens einen physischen Kenngrössenbeitrag P11-P42", mindestens eine relevante Einflussgrösse E11-E42", mindestens einen Messunsicherheitsbeitrag U11-U42" und mindestens eine messtechnische Kompatibilität O dieses Übertragungsgliedes G1-G4". Gemäss Konvention der Erfindung ist T11-T42" eine Kurzform von T11-T11", T12-T12", T13-T13", T21-T21", T22-T22", T31-T31", T32-T32", T33-T33", T41-T41", T42-T41", entsprechendes gilt für P11-P42", E11-E42" und U11-U42".

Die Bezeichnung von mindestens einem Anwendungszweck A, mindestens einem technischen Kenngrössenbeitrag T11-T42", mindestens einem physischen Kenngrössenbeitrag P11-P42", mindestens einer relevanten Einflussgrösse E11-E42", mindestens einem Messunsicherheitsbeitrag U11-U42" und mindestens einer messtechnischen Kompatibilität O für ein Übertragungsglied G1-G4" erfolgt in einem semantischen Modell (Resource Model). Im semantischen Modell werden die Übertragungsglieder G1-G4", die technischen Kenngrössenbeiträge T11-T42", die physischen Kenngrössenbeiträge P11-P42", die relevanten Einflussgrössen E11-E42", die Messunsicherheitsbeiträge U11-U42" und die messtechnischen Kompatibilitäten O als Ressourcen (Resource) dargestellt. Zwischen den Ressourcen werden eineindeutige Beziehungen (Links) geknüpft. Bei Kenntnis einer Ressource lassen sich somit alle mit dieser Ressource in Beziehung stehenden Ressourcen auffinden und aus dem Datenspeicher R2 auslesen.

Die digitalen Informationsdaten IG von Übertragungsgliedern G1-G4" bezeichnen Anwendungszwecke A von Übertragungsgliedern G1-G4". Beispielsweise lautet der Anwendungszweck A eines Übertragungsgliedes G1 in der Ausführungsform eines piezoelektrischen Sensors "Kraft erfassen" oder "Beschleunigung erfassen". Der Anwendungszweck A eines Übertragungsgliedes G2 in der Ausführungsform eines Signalkabels lautet "Signalkabel für einen piezoelektrischen Sensor". Oder der Anwendungszweck A eines Übertragungsgliedes G3 in der Ausführungsform eines elektrischen Verstärkers lautet "elektrischer Verstärker für einen piezoelektrischen Kraftsensor". Und der Anwendungszweck A eines Übertragungsgliedes G4 in der Ausführungsform einer Auswerteeinheit lautet "Auswerteeinheit für einen piezoelektrischen Sensor".

Die digitalen Informationsdaten IG von Übertragungsgliedern G1-G4" bezeichnen technische Kenngrössenbeiträge T11-T42" von Übertragungsgliedern G1-G4". Ein Übertragungsglied G1 in der Ausführungsform eines piezoelektrischen Sensors weist beispielsweise drei technische Kenngrössenbeiträge T11 "Messempfindlichkeit des piezoelektrischen Sensors", T12 "Linearität des piezoelektrischen Sensors" und T13 "Messgenauigkeit des piezoelektrischen Sensors" auf. Ein Übertragungsglied G2 in der Ausführungsform eines Signalkabels weist beispielsweise zwei technische Kenngrössenbeiträge T21 "Kabelimpedanz" und T22 "Frequenz" auf. Ein Übertragungsglied G3 in der Ausführungsform eines elektrischen Verstärkers weist beispielsweise drei technische Kenngrössenbeiträge T31 "Anzahl der Kanäle", T32 "Abtastfrequenz" und T33 "Messgenauigkeit des elektrischen Verstärkers" auf. Und ein Übertragungsglied G4 in der Ausführungsform einer Auswerteeinheit weist beispielsweise zwei technische Kenngrössenbeiträge T41 "Vielzahl der Schnittstellen" und T42 "Version des Computerprogrammproduktes" auf.

Die digitalen Informationsdaten IG von Übertragungsgliedern G1-G4" bezeichnen erste physische Kenngrössenbeiträge P11-P11", P21-P21", P31-P31", P41-P41" von Übertragungsgliedern G1-G4". Der erste physische Kenngrössenbeitrag P11-P11', P21-P21", P31-P31", P41-P41" eines Übertragungsgliedes G1-G4" besagt, ob dieses Übertragungsglied G1-G4" im vorgesehenen Zeitraum zur Erfassung der physikalischen Messgrösse M mit dem Messsystem S verfügbar ist und ob es nicht bereits für ein anderes Messsystem zur Erfassung einer anderen physikalischen Messgrösse vergeben ist.

Die digitalen Informationsdaten IG von Übertragungsgliedern G1-G4" bezeichnen zweite physische Kenngrössenbeiträge P12-P12", P22-P22', P32-P32", P42-P42" von Übertragungsgliedern G1-G4". Der zweite physische Kenngrössenbeitrag P12-P12", P22-P22", P32-P32", P42-P42" eines Übertragungsgliedes G1-G4" bezeichnet einen Beschaffungspreis dieses Übertragungsgliedes G1-G4".

Die digitalen Informationsdaten IG von Übertragungsgliedern G1-G4" bezeichnen relevante Einflussgrössen E11-E42" von Übertragungsgliedern G1-G4". Relevant ist eine Einflussgrösse E11-E42", wenn sie einen signifikanten Beitrag auf die Messunsicherheit U des Messsystems S ausübt. Vorzugsweise sind diejenigen Einflussgrössen E11-E42" relevant, welche Einflussgrössen E11-E42" die grössten Beträge an der Messunsicherheit U haben, und welche Einflussgrössen E11-E42" in Summe einen Beitrag von mindestens 80% an der Messunsicherheit U haben. Die Relevanz einer Einflussgrösse wird vorgängig ermittelt. Vorzugsweise werden bei der Feststellung der Einflussgrössen auf die Messunsicherheit U nur relevante Einflussgrössen E11-E42" berücksichtigt. Ein Übertragungsglied G1 in der Ausführungsform eines piezoelektrischen Sensors weist beispielsweise drei relevante Einflussgrössen E11 "Temperaturabhängigkeit der Messempfindlichkeit des piezoelektrischen Sensors", E12 "Zeitabstand seit der letzten Kalibrierung und Genauigkeit der Kalibrierung" und E13 "Umgebungseinflüsse" auf. Ein Übertragungsglied G2 in der Ausführungsform eines Signalkabels weist beispielsweise zwei relevante Einflussgrössen E21 "Länge des Signalkabels" und E22 "Frequenz" auf. Ein Übertragungsglied G3 in der Ausführungsform eines elektrischen Verstärkers weist beispielsweise zwei relevante Einflussgrössen E31 "Messgenauigkeit des elektrischen Verstärkers" und E32 "Übersprechen zwischen Eingangskanälen des elektrischen Verstärkers" auf. Ein Übertragungsglied G4 in der Ausführungsform einer Auswerteeinheit weist beispielsweise zwei relevante Einflussgrössen E41 "Rundungsfehler bei der Weiterbverarbeitung" und E42 "Geschwindigkeit bei der Weiterverarbeitung" auf.

Die digitalen Informationsdaten IG von Übertragungsgliedern G1-G4" bezeichnen Messunsicherheitsbeiträge U11-U42". Dazu sind im Datenspeicher R2 für relevante Einflussgrössen E11-E42" auch beste Einflussschätzwerte und den besten Einflussschätzwerten beigeordnete Messunsicherheitsbeiträge U11-U42" gespeichert. Vorzugsweise werden die beste Einflussschätzwerte und die den besten Einflussschätzwerten beigeordnete Messunsicherheitsbeiträge U11-U42" vorgängig ermittelt und sind den relevanten Einflussgrössen E11-E42" zugeordnet. Wenn also ein Übertragungsglied G1-G4" mindestens eine relevante Einflussgrösse E11-E42" aufweist, so ist der relevanten Einflussgrösse E11-E42" auch mindestens ein Messunsicherheitsbeitrag U11-U42" zugeordnet.

Auch bezeichnen die digitalen Informationsdaten IG von Übertragungsgliedern G1-G4" messtechnische Kompatibilitäten O von Übertragungsgliedern G1-G4". Die messtechnischen Kompatibilitäten O besagen, mit welchen weiteren Übertragungsgliedern G1-G4" ein Übertragungsglied G1-G4" zu einer Messkette K-K" zusammenstellbar ist. So besagen die messtechnischen Kompatibilitäten O eines Übertragungsgliedes G1 in der Ausführungsform eines piezoelektrischen Sensors, mit welchen weiteren Übertragungsgliedern G2 in der Ausführungsform eines Signalkabels und mit welchen weiteren Übertragungsgliedern G3 in der Ausführungsform eines elektrischen Verstärkers und mit welchen weiteren Übertragungsgliedern G4 in der Ausführungsform einer Auswerteeinheit dieser piezoelektrische Sensor messtechnisch kompatibel ist.

Zur Ausführung von Schritt b) liest das Computerprogrammprodukt C digitale Informationsdaten IG mit Anwendungszwecken A von Übertragungsgliedern G1-G4" ein. Die digitalen Informationsdaten IM der zu erfassenden physikalischen Messgrösse M setzt das Computerprogrammprodukt C mit den eingelesenen digitalen Informationsdaten IG von Anwendungszwecken A in Beziehung. Dabei wird mindestens ein Übertragungsglied G1-G4" ermittelt, dessen digitale Informationsdaten IG einen Anwendungszweck A bezeichnen, welcher Anwendungszweck A gleich den digitalen Informationsdaten IM zur Angabe der zu erfassenden Messgrösse M ist. Wenn die digitalen Informationsdaten IM der zu erfassenden physikalischen Messgrösse M beispielsweise "Kraft erfassen" angeben, dann ermittelt das Computerprogrammprodukt C mindestens ein Übertragungsglied G1-G1" in der Ausführungsform eines piezoelektrischen Kraftsensors, dessen digitale Informationsdaten IG den Anwendungszweck A "Kraft erfassen" bezeichnen.

Für das mindestens eine so ermittelte Übertragungsglied G1-G1" liest das Computerprogrammprodukt C daraufhin messtechnische Kompatibilitäten O ein. Aus digitalen Informationsdaten IG von messtechnischen Kompatibilitäten O des ermittelten Übertragungsgliedes G1-G1" mit weiteren Übertragungsgliedern G2-G4" stellt das Computerprogrammprodukt C mehrere Messketten K-K" für die Erfassung der angegebenen physikalischen Messgrösse M automatisiert zusammen. Beispielsweise stellt das Computerprogrammprodukt C drei Messketten K-K" zusammen, wobei vier erste Übertragungsglieder G1-G4 eine erste Messkette K bilden, vier zweite Übertragungsglieder G1'-G4' eine zweite Messkette K' bilden, vier dritte Übertragungsglieder G1"-G4" eine erste Messkette K" bilden. Dabei unterscheiden sich die zusammengestellten Messketten K-K" in mindestens einem Übertragungsglied G1-G4" voneinander. So können die erste Messkette K und die dritte Messkette K" die gleichen ersten und zweiten Übertragungsglied G1=G1", G2=G2", aber unterschiedliche dritte und vierte Übertragungsglieder G3, G3≠G3", G4≠G4" aufweisen.

Optional wird im Schritt b) mindestens ein Übertragungsglied G1-G4" ermittelt, dessen digitale Informationsdaten IG einen technischen Kenngrössenbeitrag T11-T42" oder einen physischen Kenngrössenbeitrag P11-P42" oder einen Messunsicherheitsbeitrag U11-U42" bezeichnen, welcher technische Kenngrössenbeitrag T11-T42" oder physische Kenngrössenbeitrag P11-P42" oder Messunsicherheitsbeitrag U11-U42" die digitalen Informationsdaten IM zur Vorgabe zu Leistungskriterien L-L" eindeutig erfüllt. So kann die Vorgabe zu Leistungskriterien L-L" einen technischen Kenngrössenbeitrag T31 "Vier Kanäle, ein Kanal für die Krafterfassung, drei Kanäle für die Beschleunigungserfassung" angeben. Demnach werden bei der Zusammenstellung der Messketten K-K" nur solche Übertragungsglieder G3-G3" berücksichtigt, deren digitale Informationsdaten IG einen technischen Kenngrössenbeitrag T31-T31" bezeichnen, welcher technischen Kenngrössenbeitrag T31-T31" die Vorgabe erfüllt, beispielsweise in dem der technische Kenngrössenbeitrag T31-T31" mindestens vier Kanäle lautet. Oder die Vorgabe zu Leistungskriterien L-L" gibt physische Kenngrössenbeiträge P11, P21, P31, P41 "Erfassungszeitraum vom 01.03.2020 bis 31.03.2020" an. Dann werden bei der Zusammenstellung der Messketten K-K" nur solche Übertragungsglieder G1-G4" berücksichtigt, deren digitale Informationsdaten IG physische Kenngrössenbeiträge P11-P11", P21-P21", P31-P31", P41-P41" bezeichnen, welche physische Kenngrössenbeiträge P11-P11", P21-P21", P31-P31", P41-P41" die Vorgabe erfüllen, also dass die Übertragungsglieder G1-G4" in dem vorgesehenen Zeitraum zur Erfassung der physikalischen Messgrösse M verfügbar sind. Und die Vorgabe zu Leistungskriterien L-L" kann auch pauschal eine "mittlere Messunsicherheit" als Messunsicherheit U angeben. Dann werden bei der automatisierten Zusammenstellung der Messketten K-K" nur solche Übertragungsglieder G1-G4" berücksichtigt, deren digitale Informationsdaten IG Messunsicherheitsbeiträge U11-U42" bezeichnen, welche Messunsicherheitsbeiträge U11-U42" die Vorgabe erfüllen, beispielsweise in dem extreme Messunsicherheitsbeiträge U11-U42" nicht berücksichtigt werden. Es findet also eine Filterung der Übertragungsglieder G1-G4" statt.

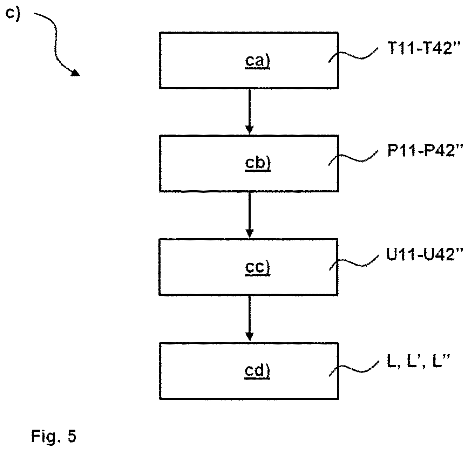

Im Schritt c) ermittelt das Computerprogrammprodukt C für jede zusammengestellte Messkette K-K" mindestens ein einer Messkette K-K" zugeordnetes Leistungskriterium L-L". Das Leistungskriterium L-L" weist mindestens eine technische Kenngrösse T-T", mindestens eine physische Kenngrösse P-P" und mindestens eine Messunsicherheit U-U" auf. Fig. 5 ist dazu ein Schema von Teilschritten ca) bis cd) beim Schritt c) .

In einem Teilschritt ca) liest das Computerprogrammprodukt C für jedes Übertragungsglied G1-G4" der zusammengestellten Messketten K-K" digitale Informationsdaten IG von technischen Kenngrössenbeiträgen T11-T42" aus dem Datenspeicher R2 ein. Das Computerprogrammprodukt C bildet die technische Kenngrösse T-T" einer Messkette K-K" aus den technischen Kenngrössenbeiträgen T11-T42" der Übertragungsglieder G1-G4" der Messkette K-K".

In einem Teilschritt cb) liest das Computerprogrammprodukt C für jedes Übertragungsglied G1-G4" der zusammengestellten Messketten K-K" digitale Informationsdaten IG von physischen Kenngrössenbeiträgen P11-P42" aus dem Datenspeicher R2 ein. Das Computerprogrammprodukt C bildet die physische Kenngrösse P-P" einer Messkette K-K" aus den physischen Kenngrössenbeiträgen P11-P42" der Übertragungsglieder G1-G4" der Messkette K-K".

In einem Teilschritt cc) liest das Computerprogrammprodukt C für jedes Übertragungsglied G1-G4" der zusammengestellten Messketten K-K" Messunsicherheitsbeiträge U11-U42" aus dem Datenspeicher R2 ein. Das Computerprogrammprodukt C bildet die Messunsicherheit U-U" einer Messkette K-K", in dem es eine Quadratwurzel einer Summe der Quadrate von Messunsicherheitsbeiträgen U11-U42" der Übertragungsglieder G1-G4" der Messkette K-K" berechnet.

In einem Teilschritt cd) bildet das Computerprogrammprodukt C Leistungskriterien L-L" der zusammengestellten Messketten K-K", in dem es für jede Messkette K-K" die technische Kenngrösse T-T", die physische Kenngrösse P-P" und die Messunsicherheit U-U" dieser Messkette K-K" zusammenträgt.

Im Schritt d) erfolgt ein Vergleich der zusammengestellten Messketten K-K" miteinander anhand der ermittelten Leistungskriterien L-L". Dazu zeigt Fig. 6 eine Ausgabeeinheit R4 des Rechensystems R. Auf der Ausgabeeinheit R4 ist eine Tabelle mit beispielsweise drei Spalten I-III und drei Zeilen dargestellt. Eine erste Spalte I gibt technische Kenngrössenbeiträge T11-T42" wieder, eine zweite Spalte II gibt physische Kenngrössenbeiträge P11-P42" wieder und eine dritte Spalte III gibt Messunsicherheitsbeiträge U11-U42" wieder. Eine erste Zeile gibt die technischen Kenngrössenbeiträge T11-T42, die physischen Kenngrössenbeiträge P11-P42 und die Messunsicherheitsbeiträge U11-U42 des Leistungskriteriums L der ersten Messkette K wieder. Eine zweite Zeile gibt die technischen Kenngrössenbeiträge T11"-T42", die physischen Kenngrössenbeiträge P11"-P42" und die Messunsicherheitsbeiträge U11"-U42" des Leistungskriteriums L" der dritten Messkette K" wieder. Eine dritte Zeile gibt die technischen Kenngrössenbeiträge T11'-T42', die physischen Kenngrössenbeiträge P11'-P42' und die Messunsicherheitsbeiträge U11'-U42' des Leistungskriteriums L' der zweiten Messkette K' wieder. Somit kann der Benutzer die zusammengestellten Messketten K-K" anhand der ermittelten Leistungskriterien L-L" leistungsspezifisch miteinander vergleichen. Beispielsweise erkennt der Benutzer Unterschiede bei den physischen Kenngrössen P11-P42" der Übertragungsglieder G1-G4" der drei zusammengestellten Messketten K-K". So kann der Benutzer anhand der ersten physischen Kenngrössen P11-P11", P21-P21", P31-P31", P41-P41" erkennen, welche Übertragungsglieder G1-G4" im vorgesehenen Zeitraum zur Erfassung der physikalischen Messgrösse M mit dem Messsystem S verfügbar sind.

Im Schritt e) erfolgt eine Identifizierung einer Messkette K*, welche Messkette K* eines der ermittelten Leistungskriterien L-L" am besten erfüllt. Dazu kann das Computerprogrammprodukt C eine Rangbildung vorschlagen. Dazu nimmt der Benutzer in der auf der Ausgabeeinheit R4 dargestellten Tabelle eine leistungsspezifische Rangbildung vor. Die zusammengestellten Messketten K-K" werden anhand einer Grösse der technischen Kenngrössenbeiträge T11-T42" und/oder der physischen Kenngrössenbeiträge P11-P42" und/oder der Messunsicherheitsbeiträge U11-U42" der ermittelten Leistungskriterien L-L" im Rang angeordnet. Im Sinne der Erfindung bezeichnet die Konjunktion "und/oder" sowohl eine logische Verknüpfung UND ans auch eine logische Verknüpfung OR.

Eine solche leistungsspezifische Rangbildung ist in Fig. 6 schematisch durch einen fettes Dreieck ober halb der zweiten Spalte II wiedergegeben. In diesem Beispiel hat der Benutzer eine Rangfolge der drei zusammengestellten Messketten K-K" nach deren physischen Kenngrössenbeiträgen P11-P42" gebildet. Die physischen Kenngrössenbeiträge P11-P42" sind in Grösse aufsteigend nach "Verfügbarkeit" und "Beschaffungspreis" der Übertragungsglieder G1-G4" sortiert. Die physischen Kenngrössen P11-P42 der ersten Messkette K sind im ersten Rang in der ersten Zeile angeordnet, die physischen Kenngrössen P11"-P42" der dritten Messkette K" sind im zweiten Rang in der zweiten Zeile angeordnet und die physischen Kenngrössen P11'-P42' der zweiten Messkette K' sind im dritten Rang in der dritten Zeile angeordnet. Demnach erfüllt die erste Messkette K die physischen Kenngrössen P11-P42" der ermittelten Leistungskriterien L-L" am besten, beispielsweise haben die Übertragungsglieder G1-G4 der ersten Messkette K erste physische Kenngrössen P11, P21, P31, P41 mit der besten "Verfügbarkeit". Der Benutzer kann die erste Messkette K identifizieren und als identifizierte Messkette K* kennzeichnen, was in Fig. 6 durch einen schwarzen Rahmen wiedergegeben ist. Beispielsweise identifiziert der Benutzer die Messkette K in dem er auf einer Eingabeeinheit R3 in der Ausführungsform einer Computer-Tastatur die Buchstaben "Messkette K" eingibt. Oder der Benutzer identifiziert die Messkette K, in dem er die erste Zeile der auf der Ausgabeeinheit R4 in der Ausführungsform eines berührungsempfindlichen Bildschirms dargestellten Tabelle berührt.

Das Computerprogrammprodukt C kann ein nicht verfügbares Übertragungsglied G1-G4" verfügbar machen, beispielsweise in dem es einen Prozess auslöst, dass ein am Ort des Messsystems S nicht vorhandenes Übertragungsglied G1-G4" bestellt und an den Ort des Messsystems S geliefert wird.

### Bezugszeichenliste

- a): Angabe der zu erfassenden physikalischen Messgrösse
- b): Automatisierte Zusammenstellung mehrerer Messketten mit für die Erfassung der angegebenen physikalischen Messgrösse notwendigen Übertragungsgliedern
- c): Ermittlung von Leistungskriterien der zusammengestellten Messketten
- ca): Einlesen von technischen Kenngrössenbeiträgen und Berechnung der technischen Kenngrössen der zusammengestellten Messketten
- cb): Einlesen von physischen Kenngrössenbeiträgen und Berechnung von physischen Kenngrössen der zusammengestellten Messketten
- cc): Einlesen von Messunsicherheitsbeiträgen und Berechnung von Messunsicherheiten der zusammengestellten Messketten
- cd): Berechnung von Leistungskriterien der zusammengestellten Messketten aus technischen Kenngrössen, physischen Kenngrössen und Messunsicherheiten
- d): Vergleich der zusammengestellten Messketten miteinander anhand der ermittelten Leistungskriterien
- e): Identifizierung einer Messkette, welche Messkette eines der ermittelten Leistungskriterien am besten erfüllt
- C: Computerprogrammprodukt
- A: Anwendungszweck
- E11-E42": relevante Einflussgrösse
- G1-G4": Übertragungsglied
- I-III: Spalte
- IG: digitale Informationsdaten eines Übertragungsgliedes
- IM: digitale Informationsdaten der zu erfassenden physikalischen Messgrösse
- K-K": Messkette
- K*: identifizierte Messkette
- L-L": Leistungskriterium
- M: physikalische Messgrösse
- M1-M5: Eingabefeld
- O: messtechnische Kompatibilität
- P: physische Kenngrösse
- P11-P42": physischer Kenngrössenbeitrag
- R: Rechensystem
- R1: Datenverarbeitungsprozessor
- R2: Datenspeicher
- R3: Eingabeeinheit
- R4: Ausgabeeinheit
- R5: Kommunikationseinheit
- S: Messsystem
- T: technische Kenngrösse
- T11-T42": technischer Kenngrössenbeitrag
- U: Messunsicherheit
- U11-U42": Messunsicherheitsbeitrag
- V: Verfahren

## Patentansprüche

1. Verfahren (V) zur : Ermittlung einer bestmöglichen Messkette aus mehreren Messketten für die Erfassung einer physikalischen Messgrösse (M) durch ein Messsystem (S); welches Messsystem (S) mehrere Übertragungsglieder (G1-G4) aufweist; und welche Übertragungsglieder (G1-G4) : zur Bildung verschiedener Messketten (K) für die Erfassung der physikalischen Messgrösse (M) geeignet sind, wobei in den Messketten (K) jeweils direkt benachbarte Übertragungsglieder (G1-G4) in einer Ursache-Wirkung-Beziehung zueinander stehen; das Verfahren umfassend die Schritte:
a) Angabe der zu erfassenden physikalischen Messgrösse (M) ;
b) Automatisierte Zusammenstellung mehrerer Messketten (K-K") mit für die Erfassung der angegebenen physikalischen Messgrösse (M) notwendigen Übertragungsgliedern (G1-G4");
c) Automatisierte Ermittlung von Leistungskriterien (L-L") der zusammengestellten Messketten (K-K");
d) Vergleich der zusammengestellten Messketten (K-K") miteinander anhand der ermittelten Leistungskriterien (L-L"); und
e) Identifizierung einer Messkette (K*), welche identifizierte Messkette (K*) eines der ermittelten Leistungskriterien (L-L") am besten erfüllt.

2. Verfahren (V) nach Anspruch 1, **dadurch gekennzeichnet, dass** digitale Informationsdaten (IG) einer Vielzahl von Übertragungsgliedern (G1-G4") bereitgestellt werden, welche digitalen Informationsdaten (IG) für jedes Übertragungsglied (G1-G4") mindestens einen Anwendungszweck (A) bezeichnen; dass im Schritt a) digitale Informationsdaten (IM) zur Angabe der zu erfassenden physikalischen Messgrösse (M) erzeugt werden; und dass im Schritt b) mindestens ein Übertragungsglied (G1-G4") ermittelt wird, dessen digitale Informationsdaten (IG) einen Anwendungszweck (A) bezeichnen, welcher Anwendungszweck (A) gleich den digitalen Informationsdaten (IM) zur Angabe der zu erfassenden Messgrösse (M) ist.

3. Verfahren (V) nach Anspruch 2, **dadurch gekennzeichnet, dass** die digitalen Informationsdaten (IG) für jedes Übertragungsglied (G1-G4") mindestens eine messtechnische Kompatibilität (O) bezeichnen; und dass im Schritt b) Übertragungsglieder (G1-G4") ermittelt werden, deren digitale Informationsdaten (IG) eine messtechnische Kompatibilität (O) bezeichnen, welche messtechnische Kompatibilität (O) mit der messtechnische Kompatibilität (O) desjenigen Übertragungsgliedes (G1-G4") kompatibel ist, dessen Anwendungszweck (A) gleich den digitalen Informationsdaten (IM) zur Angabe der zu erfassenden Messgrösse (M) ist.

4. Verfahren (V) nach Anspruch 3, **dadurch gekennzeichnet, dass** im Schritt b) mehrere Messketten (K-K") mit für die Erfassung der angegebenen physikalischen Messgrösse (M) notwendigen Übertragungsgliedern (G1-G4") zusammengestellt werden, welche zusammengestellten Messketten (K-K") sich in mindestens einem Übertragungsglied (G1-G4") voneinander unterscheiden.

5. Verfahren (V) nach einem der Ansprüche 2 bis 4, **dadurch gekennzeichnet, dass** die digitalen Informationsdaten (IG) für jedes Übertragungsglied (G1-G4") mindestens einen technischen Kenngrössenbeitrag (T11-T42") und mindestens einen physischen Kenngrössenbeitrag (P11-P42") und mindestens einen Messunsicherheitsbeitrag (U11-U42") bezeichnen, wobei ein erster physischer Kenngrössenbeitrag (P11-P11", P21-P21", P31-P31", P41-P41") besagt, ob ein Übertragungsglied (G1-G4") in einem vorgesehenen Zeitraum zur Erfassung der physikalischen Messgrösse (M) mit dem Messsystem (S) verfügbar ist, und wobei ein zweiter physischer Kenngrössenbeitrag (P12-P12", P22-P22'', P32-P32", P42-P42") einen Beschaffungspreis eines Übertragungsgliedes (G1-G4") bezeichnet; dass im Schritt a) digitale Informationsdaten (IG) zu einer Vorgabe zu Leistungskriterien (L-L") erzeugt werden; und dass im Schritt b) nur solche Übertragungsglieder (G1-G4") berücksichtigt werden, deren digitale Informationsdaten (IG) einen technischen Kenngrössenbeitrag (T11-T42") oder einen physischen Kenngrössenbeitrag (P11-P42'') oder einen Messunsicherheitsbeitrag (U11-U42") bezeichnen, welcher technische Kenngrössenbeitrag (T11-T42'') oder physische Kenngrössenbeitrag (P11-P42") oder Messunsicherheitsbeitrag (U11-U42'') die digitalen Informationsdaten (IM) zur Vorgabe zu Leistungskriterien (L-L") eindeutig erfüllt.

6. Verfahren (V) nach einem der Ansprüche 2 bis 5, **dadurch gekennzeichnet, dass** im Schritt c) für jede zusammengestellte Messkette (K-K") mindestens ein Leistungskriterium (L-L") ermittelt wird, welches Leistungskriterium (L-L") mindestens eine technische Kenngrösse (T-T") und mindestens eine physische Kenngrösse (P-P") und mindestens eine Messunsicherheit (U-U") aufweist.

7. Verfahren (V) nach Anspruch 6, **dadurch gekennzeichnet, dass** im Schritt c) das Leistungskriterium (L-L") einer zusammengestellten Messkette (K-K") aus der technischen Kenngrösse (T-T") und der physischen Kenngrösse (P-P") und der Messunsicherheit (U-U") dieser zusammengestellten Messkette (K-K") gebildet wird.

8. Verfahren (V) nach einem der Ansprüche 6 oder 7, **dadurch gekennzeichnet, dass** die digitalen Informationsdaten (IG) für jedes Übertragungsglied (G1-G4") einer zusammengestellten Messkette (K-K") mindestens einen technischen Kenngrössenbeitrag (T11-T42) bezeichnen; und dass im Schritt c) die technische Kenngrösse (T-T") aus den technischen Kenngrössenbeiträge (T11-T42") der Übertragungsglieder (G1-G4") der zusammengestellten Messkette (K-K") gebildet wird.

9. Verfahren (V) nach einem der Ansprüche 6 bis 8, **dadurch gekennzeichnet, dass** die digitalen Informationsdaten (IG) für jedes Übertragungsglied (G1-G4") einer zusammengestellten Messkette (K-K") mindestens einen physischen Kenngrössenbeitrag (P11-P42) bezeichnen; und dass im Schritt c) die physische Kenngrösse (P-P") aus den physischen Kenngrössenbeiträge (P11-P42") der Übertragungsglieder (G1-G4") der zusammengestellten Messkette (K-K") gebildet wird.

10. Verfahren (V) nach einem der Ansprüche 6 bis 9, **dadurch gekennzeichnet, dass** die digitalen Informationsdaten (IG) für jedes Übertragungsglied (G1-G4") einer zusammengestellten Messkette (K-K") mindestens einen Messunsicherheitsbeitrag (U11-U42) bezeichnen; und dass im Schritt c) die Messunsicherheit (U-U") als eine Quadratwurzel einer Summe der Quadrate von Messunsicherheitsbeiträgen (U11-U42") der Übertragungsglieder (G1-G4") der zusammengestellten Messkette (K-K") berechnet wird.

11. Verfahren (V) nach einem der Ansprüche 6 bis 10, **dadurch gekennzeichnet, dass** im Schritt d) die zusammengestellten Messketten (K-K") tabellarisch dargestellt werden; und dass die zusammengestellten Messketten (K-K") anhand der technischen Kenngrössenbeiträge (T11-T42") und der physischen Kenngrössenbeiträge (P11-P42") und der Messunsicherheitsbeiträge (U11-U42") der ermittelten Leistungskriterien (L-L") leistungsspezifisch vergleichbar dargestellt werden.

12. Verfahren (V) nach Anspruch 11, **dadurch gekennzeichnet, dass** im Schritt e) eine leistungsspezifische Rangbildung der zusammengestellten Messketten (K-K") vorgenommen wird, wobei die zusammengestellten Messketten (K-K") anhand einer Grösse der technischen Kenngrössenbeiträge (T11-T42") und/oder der physischen Kenngrössenbeiträge (P11-P42'') und/oder der Messunsicherheitsbeiträge (U11-U42") der ermittelten Leistungskriterien (L-L") im Rang angeordnet werden.

13. Computerprogrammprodukt (C), umfassend Befehle, die bei der Ausführung des Programms durch einen Computer (R) diesen veranlassen, das Verfahren (V) nach einem der Ansprüche 1 bis 12 auszuführen, wobei
das Computerprogrammprodukt (C) in einen Datenverarbeitungsprozessor (R1) des Computers (R) ladbar ist.

## Claims

1. A method (V) for determining a best possible measuring chain of several measuring chains for the detection of a physical measured variable (M) by means of a measuring system (S); which measuring system (S) comprises a plurality of transmission members (G1-G4); and which transmission members (G1-G4) are adapted to form several measuring chains (K) for measuring the physical measured variable (M), wherein transmission members (G1-G4) that are directly adjacent in the measuring chains (K) are in a cause-and-effect relationship to each other; **characterized by** the steps of:
a) specifying the physical measured variable (M) to be detected;
b) automated compilation of a plurality of measuring chains (K-K") comprising transmission members (G1-G4") necessary for the detection of the specified physical measured variable (M);
c) automated determination of performance criteria (L-L") of the compiled measuring chains (K-K");
d) comparing the compiled measuring chains (K-K") with each other on the basis of the determined performance criteria (L-L"); and
e) identifying a measuring chain (K*) which identified measuring chain (K*) best satisfies one of the determined performance criteria (L-L").

2. The method (V) according to claim 1, **characterized in that** digital information data (IG) of a great number of transmission members (G1-G4") is available, which digital information data (IG) indicates for each transmission member (G1-G4") at least one intended application (A); wherein in step a) is generated digital information data (IM) for specifying the physical measured variable (M) to be detected; and in step b) at least one transmission member (G1-G4") is determined whose digital information data (IG) indicates an intended application (A), which intended application (A) corresponds to the digital information data (IM) for specifying the measured variable to be detected (M).

3. The method (V) according to claim 2, **characterized in that** for each transmission member (G1-G4") the digital information data (IG) indicates at least one metrological compatibility (O); and in step b) transmission members (G1-G4") are determined whose digital information data (IG) indicates a metrological compatibility (O) which is compatible with the metrological compatibility (O) of that transmission member (G1-G4") whose intended application (A) corresponds to the digital information data (IM) for specifying the measured variable (M) to be detected.

4. The method (V) according to claim 3, **characterized in that** in step b) are compiled a plurality of measuring chains (K-K") comprising transmission members (G1-G4") necessary for the detection of the specified physical measured variable (M), which compiled measuring chains (K-K") differ from each other in at least one transmission member (G1-G4").

5. The method (V) according to any of claims 2 to 4, **characterized in that** for each transmission member (G1-G4") the digital information data (IG) indicates at least one technical parameter contribution (T11-T42") and at least one physical characteristic contribution (P11-P42") and at least one measurement uncertainty contribution (U11-U42"); in step a) are generated digital information data (IG) with respect to a specification of performance criteria (L-L"); and in step b) only those transmission members (G1-G4") are considered whose digital information data (IG) indicates a technical parameter contribution (T11-T42") or a physical characteristic contribution (P11-P42") or a measurement uncertainty contribution (U11-U42"), which technical parameter contribution (T11-T42") or physical characteristic contribution (P11-P42") or measurement uncertainty contribution (U11-U42") clearly satisfies the digital information data (IM) for the specification of performance criteria (L-L").

6. The method (V) according to any of claims 2 to 5, **characterized in that** in step c) at least one performance criterion (L-L") is determined for each compiled measuring chain (K-K"), which performance criterion (L-L") comprises at least a technical parameter (T-T") and at least one physical characteristic (P-P") and at least one measurement uncertainty (U-U").

7. The method (V) according to claim 6, **characterized in that** in step c) the performance criterion (L-L") of a compiled measuring chain (K-K") is calculated from the technical parameter (T-T") and the physical characteristic (P-P") and the measurement uncertainty (U-U") of this compiled measuring chain (K-K").

8. The method (V) according to any of claims 6 or 7, **characterized in that** the digital information data (IG) for each transmission member (G1-G4") of a compiled measuring chain (K-K") indicates at least one technical parameter contribution (T11-T42); and in step c) the technical parameter (T-T") is calculated from the technical parameter contributions (T11-T42") of the transmission members (G1-G4") of the compiled measuring chain (K-K").

9. The method (V) according to any of claims 6 to 8, **characterized in that** the digital information data (IG) for each transmission member (G1-G4") of a compiled measuring chain (K-K") indicates at least one physical characteristic contribution (P11-P42); and in step c) the physical characteristic (P-P") is calculated from the physical characteristic contributions (P11-P42") of the transmission members (G1-G4") of the compiled measuring chain (K-K").

10. The method (V) according to any of claims 6 to 9, **characterized in that** the digital information data (IG) for each transmission member (G1-G4") of a compiled measuring chain (K-K") indicates at least one measurement uncertainty contribution (U11-U42); and in step c) the measurement uncertainty (U-U") is calculated as a square root of a sum of the squares of measurement uncertainty contributions (U11-U42") of the transmission members (G1-G4") of the compiled measuring chain (K-K").

11. The method (V) according to any of claims 6 to 10, **characterized in that** in step d) the compiled measuring chains (K-K") are represented in the form of a table; and **in that** the compiled measuring chains (K-K") are displayed for comparison in a performance-specific manner on the basis of the technical parameter contributions (T11-T42") and the physical characteristic contributions (P11-P42") and the measurement uncertainty contributions (U11-U42") of the determined performance criteria (L-L").

12. The method (V) according to claim 11, **characterized in that** in step e) a performance-specific ranking of the compiled measuring chains (K-K") is carried out wherein the compiled measuring chains (K-K") are ranked on the basis of an amount of the technical parameter contributions (T11-T42") and/or the physical characteristic contributions (P11-P42") and/or the measurement uncertainty contributions (U11-U42") of the performance criteria (L-L") determined.

13. A computer program product (C), comprising instructions, that when the program is executed by a computer (R), cause the computer (R) to perform the method (V) according to any of claims 1 to 12, **whereby** the computer program product (C) is loadable into a data processing processor (R1) of the computer (R).

## Revendications

1. Procédé (V) pour déterminer une chaîne de mesure optimale parmi une pluralité de chaînes de mesure pour la détection d'une variable physique mesurée (M) au moyen d'un système de mesure (S); lequel système de mesure (S) comprenant une pluralité d'éléments de transmission (G1-G4); et lesdits éléments de transmission (G1-G4) étant aptes à former des chaînes de mesure (K) différents pour la détection de la variable physique mesurée (M), dans lequel il y a une relation de cause à effet entre les éléments de transmission (G1-G4) se situant directement adjacents dans lesdites chaînes de mesure (K); ledit procédé comprenant les étapes consistant à:
a) la spécification de la variable physique mesurée (M) à détecter;
b) la compilation automatisée d'une pluralité de chaînes de mesure (K-K") comprenant les éléments de transmission (G1-G4") nécessaires pour la détection de la variable physique mesurée (M) spécifiée;
c) la détermination automatisée des critères de performance (L-L") des chaînes de mesure (K-K") compilées;
d) la comparaison des chaînes de mesure (K-K") compilées entre elles sur la base desdits critères de performance (L-L") déterminés; et
e) la identification d'une chaîne de mesure (K*), ladite chaîne de mesure (K*) identifiée satisfaisant le mieux l'un des critères de performance (L-L") déterminés.

2. Procédé (V) selon la revendication 1, **caractérisé en ce que** des données d'information numériques (IG) d'une pluralité d'éléments de transmission (G1-G4") sont fournies, lesquelles données d'information numériques (IG) indiquant pour chaque élément de transmission (G1-G4") au moins une application prévue (A); **en ce que** des données d'informations numériques (IM) pour spécifier la variable physique mesurée (M) à détecter sont générées à l'étape a); et **en ce qu'**au moins un élément de transmission (G1-G4") est déterminé à l'étape b) dont les données d'information numériques (IG) indiquent une application prévue (A), laquelle application prévue (A) correspondant aux données d'information numériques (IM) spécifiant la variable mesurée (M) à détecter.

3. Procédé (V) selon la revendication 2, **caractérisé en ce que** les données d'information numériques (IG) indiquent pour chaque élément de transmission (G1-G4") au moins une compatibilité métrologique (O); et **en ce que** des éléments de transmission (G1-G4") sont déterminés à l'étape b) dont les données d'information numériques (IG) indiquent une compatibilité métrologique (O), ladite compatibilité métrologique (O) étant compatible avec la compatibilité métrologique (O) de l'élément de transmission (G1-G4") dont l'application prévue (A) correspond aux données d'information numériques (IM) spécifiant la variable mesurée (M) à détecter.

4. Procédé (V) selon la revendication 3, **caractérisé en ce que** plusieurs chaînes de mesure (K-K") sont compilées à l'étape b) avec les éléments de transmission (G1-G4") nécessaires pour la détection de la variable physique mesurée (M) spécifiée, dans lequel lesdites chaînes de mesure (K-K") compilées diffèrent les unes des autres dans au moins un élément de transmission (G1-G4").

5. Procédé (V) selon l'une quelconque des revendications 2 à 4, **caractérisé en ce que** les données d'information numériques (IG) indiquent pour chaque élément de transmission (G1-G4") au moins une contribution à la valeur caractéristique technique (T11-T42") et au moins une contribution à la valeur caractéristique physique (P11-P42") et au moins une contribution à l'incertitude de mesure (U11-U42"), dans lequel une première contribution à la valeur caractéristique physique (P11-P11", P21-P21", P31-P31", P41-P41") indique si un élément de transmission (G1-G4") soit disponible dans la période de temps envisagée pour la détection de la valeur mesurée physique (M) avec le système de mesure (S), et dans lequel une seconde contribution à la valeur caractéristique physique (P12-P12", P22-P22", P32-P32", P42-P42") indique un prix d'acquisition d'un élément de transmission (G1-G4"); **caractérisé en ce que** des données d'information numériques (IG) pour une spécification par rapport à des critères de performance (L-L") sont générées à l'étape a); et **en ce que** seuls les éléments de transmission (G1-G4") sont considérés à l'étape b) dont les données d'information numériques (IG) indiquent une contribution à la valeur caractéristique technique (T11-T42") ou une contribution à la valeur caractéristique physique (P11-P42") ou une contribution à l'incertitude de mesure (U11-U42''), laquelle contribution à la valeur caractéristique technique (T11-T42") ou à la valeur caractéristique physique (P11-P42") ou laquelle contribution à l'incertitude de mesure (U11-U42") satisfaisant précisément les données d'information numériques (IM) pour la spécification par rapport à des critères de performance (L-L").

6. Procédé (V) selon l'une quelconque des revendications 2 à 5, **caractérisé en ce qu'**au moins un critère de performance (L-L") est déterminé à l'étape c) pour chaque chaîne de mesure (K-K") compilée, lequel critère de performance (L-L") comprenant au moins une valeur caractéristique technique (T-T") et au moins une valeur caractéristique physique (P-P") et au moins une incertitude de mesure (U-U").

7. Procédé (V) selon la revendication 6, **caractérisé en ce que** ledit critère de performance (L-L") d'une chaîne de mesure (K-K") compilée est calculé à l'étape c) à partir de la valeur caractéristique technique (T-T") et de la valeur caractéristique physique (P-P") et de l'incertitude de mesure (U-U") de cette chaîne de mesure (K-K") compilée.

8. Procédé (V) selon l'une quelconque des revendications 6 ou 7, **caractérisé en ce que** les données d'information numériques (IG) pour chaque élément de transmission (G1-G4") d'une chaîne de mesure (K-K") compilée indiquent au moins une contribution à la valeur caractéristique technique (T11-T42); et **en ce que** la valeur caractéristique technique (T-T") est calculée à l'étape c) à partir des contributions à la valeur caractéristique technique (T11-T42") des éléments de transmission (G1-G4") de la chaîne de mesure (K-K") compilée.

9. Procédé (V) selon l'une quelconque des revendications 6 à 8, **caractérisé en ce que** les données d'information numériques (IG) pour chaque élément de transmission (G1-G4") d'une chaîne de mesure (K-K") compilée indiquent au moins une contribution à la valeur caractéristique physique (P11-P42); et **en ce que** la valeur caractéristique physique (P-P") est calculée à l'étape c) à partir des contributions à la valeur caractéristique physique (P11-P42") des éléments de transmission (G1-G4") de la chaîne de mesure (K-K") compilée.

10. Procédé (V) selon l'une quelconque des revendications 6 à 9, **caractérisé en ce que** les données d'information numériques (IG) pour chaque élément de transmission (G1-G4") d'une chaîne de mesure (K-K") compilée indiquent au moins une contribution à l'incertitude de mesure (U11-U42); et **en ce que** l'incertitude de mesure (U-U") est calculée à l'étape c) en tant que racine carrée d'une somme des carrés des contributions à l'incertitude de mesure (U11-U42") des éléments de transmission (G1-G4") de la chaîne de mesure (K-K") compilée.

11. Procédé (V) selon l'une quelconque des revendications 6 à 10, **caractérisé en ce que** les chaînes de mesure (K-K") compilées sont représentées sous la forme d'un tableau à l'étape d); et **en ce que** lesdites chaînes de mesure (K-K'') compilées sont affichées à des fins de comparaison d'une manière spécifique en ce qui concerne leur performance sur la base des contributions à la valeur caractéristique technique (T11-T42") et des contributions à la valeur caractéristique physique (P11-P42") et des contributions à l'incertitude de mesure (U11-U42") des critères de performance (L-L") déterminés.

12. Procédé (V) selon la revendication 11, **caractérisé en ce qu'un** classement des chaînes de mesure (K-K") compilées spécifique en ce qui concerne leur performance est effectué à l'étape e), dans lequel les chaînes de mesure (K-K") compilées sont classées sur la base d'une grandeur des contributions à la valeur caractéristique technique (T11-T42") et/ou des contributions à la valeur caractéristique physique (P11-P42") et/ou des contributions à l'incertitude de mesure (U11-U42") des critères de performance (L-L") déterminés.

13. Produit programme informatique (C) comprenant commandes qui, lors la mise en œuvre du programme par un ordinateur, l'inciteront à exécuter le procédé (V) selon l'une quelconque des revendications 1 à 12, ledit produit programme informatique (C) étant chargeable dans un processeur pour le traitement de données (R1) de l'ordinateur.
